# EUROPÄISCHE PATENTSCHRIFT

(11) **EP 0 461 493 B1**
(45) Veröffentlichungstag und Bekanntmachung des Hinweises auf die Patenterteilung: **25.09.1996**
(21) Anmeldenummer: 91108940.7
(22) Anmeldetag: 31.05.1991
(51) Int. Cl.: G01R 33/31, B01L 7/00

(54) **Probentemperiervorrichtung**
Means for generating the temperature of a sample
Dispositif pour établir la température d'un échantillon

(30) Priorität: 12.06.1990 DE 4018734
(43) Veröffentlichungstag der Anmeldung: 18.12.1991
(73) Patentinhaber: SPECTROSPIN AG, CH-8117 Fällanden (CH)
(72) Erfinder: Hepp, Phillip, CH-4102 Binningen (CH); Tschopp, Werner, H., Dr., CH-8127 Aesch/Forch (CH); Rindlisbacher, Martin, CH-8053 Zürich (CH); Schett, Oskar, CH-8610 Uster (CH)
(74) Vertreter: KOHLER SCHMID + PARTNER

(56) Entgegenhaltungen:
- DE-A- 3 027 891
- GB-A- 1 196 820
- REVIEW OF SCIENTIFIC INSTRUMENTS. Bd. 52, Nr. 3, März 1981, NEW YORK, USA Seiten 382 - 385; N. YOSHIDA ET AL.: 'Modified variable temperature control unit for NMR spectrometers'
- JOURNAL OF MAGNETIC RESONANCE, Bd. 87, Nr. 3, Mai 1990, DULUTH, USA Seiten 592 - 597; F. AGUILAR-PARRILLA ET AL.: 'Temperature Gradients and Sample Heating in Variable Temperature High Speed MAS NMR Spectrometry'
- PATENT ABSTRACTS OF JAPAN vol. 14, no. 92 (P-1009)20. Februar 1990 &JP-A-1 299 448 (JEOL LTD.) 4.Dezember 1989 * Zusammenfassung*

## Beschreibung

Die Erfindung betrifft eine Probentemperiervorrichtung, insbesondere für die NMR-Spektroskopie, mit einem Behälter, der eine Öffnung zur Aufnahme einer Meßprobe, eine Eintrittsöffnung zum Einlassen eines Fluids, eine Austrittsöffnung für den Austritt des Fluids und einen Strömungskanal, durch den zumindest ein Teilstrom des Fluids als direkter Fluidstrom von unten nach oben an der Meßprobe vorbeigeführt wird, aufweist.

Eine solche Vorrichtung ist zum Beispiel aus der WO 85/04020 bekannt.

Bei der Untersuchung von Proben, insbesondere in der NMR-Spektroskopie, aber z. B. auch in der optischen Spektroskopie und in der Infrarot-Spektroskopie ,ist es oft notwendig, gewisse Probensubstanzen bei unterschiedlichen Temperaturen zu messen. Dabei verändern sich in der Regel die Spektren, da einerseits die Höhen und Breiten und andererseits die Resonanzfrequenzen der Spektrallinien temperaturabhängig sein können.

Will man diese Temperaturabhängigkeit der Spektren genau erfassen, dann ist es notwendig, eine konstante Temperaturverteilung über dem gesamten aktiven Probenvolumen zu erreichen. Ist dies nicht der Fall, dann treten Verfälschungen des gewünschten Effektes auf, indem einzelne Volumenelemente innerhalb der Probe verschiedene Temperaturen besitzen und damit vor allem bei der NMR-Spektroskopie verschiedenartige Linien mit verschobenen Resonanzstellen hervorrufen, die sich überlagern können und dadurch zu verzerrten Linienformen führen.

Die bekannten Temperiervorrichtungen, vor allem für die NMR-Spektroskopie, aber auch für die optische und die Infrarot-Spektroskopie funktionieren im allgemeinen so, daß ein gekühltes oder erwärmtes Fluid, vorzugsweise Stickstoffgas, an der Oberfläche einer zylinderförmigen Meßprobe von unten nach oben entlangströmt, um die Meßprobe auf die gewünschte Temperatur zu bringen.

Zur Verbesserung der spektralen Auflösung muß die Meßprobe in den meisten Fällen rotiert werden. Dies geschieht, indem der obere Bereich des Probengläschens, das das Probenmaterial enthält, in den Rotor einer Luftturbine gestellt wird, wodurch das Probengläschen einerseits richtig positioniert wird und andererseits rotiert werden kann.

Diese Art der Probenhalterung hat jedoch einerseits zur Folge, daß der obere Bereich des Probengläschens nicht hermetisch abgeschlossen werden kann und daß somit der untere Teil, der einen hermetischen Abschluß erlaubt, für den Eintritt des Fluids vorgezogen wird. Dies bedeutet, daß der Fluidstrom vorzugsweise von unten nach oben entlang dem Probengläschen geführt wird.

Andererseits hat diese Art der Probenhalterung zur Folge, daß im Falle der Erwärmung der Meßprobe diese unten stärker erwärmt wird als oben, da oben über die Kontaktstelle zwischen Probengläschen und Luftturbine Wärme abgeführt wird. Diese Kontaktstelle ist maßgebend dafür verantwortlich, daß ein Temperaturgradient in axialer Richtung im Probengläschen entsteht. Um diesem Temperaturgradienten entgegenzuwirken, wäre es wünschenswert, das Fluid von oben nach unten entlang dem Probengläschen fließen zu lassen, was aber, wie oben erläutert, auf technische Schwierigkeiten stößt.

Bei einer anderen bekannten Anordnung wird eine verbesserte Temperaturhomogenität innerhalb der Meßprobe dadurch erreicht, daß das temperierende Fluid in einer Art Gegenstromverfahren zur Probenunterseite geführt wird. Dabei strömt das Fluid zunächst von oben nach unten an den Wänden eines Glasröhrchens vorbei, in dem sich das Probengläschen mit der Meßprobe befindet. Das Glasröhrchen ist unten offen, so daß das Fluid an dieser Stelle von unten nach oben in den Raum zwischen dem Glasröhrchen und der Meßprobe strömen kann, von wo es dann in direktem Kontakt mit dem Probengläschen entlang der Meßprobe von unten nach oben strömt. Falls nun das Fluid beispielsweise die Probe erwärmen soll, wird in diesem Falle das Glasröhrchen oben stärker erwärmt als unten, und trägt deshalb aufgrund einer radialen Wärmeübertragung in Richtung auf die Probe dazu bei, den von unten nach oben entstehenden Temperaturabfall im Probengläschen zu verringern. Dieser dem Temperaturgradienten entgegenwirkende Effekt ist aber nur sehr beschränkt, weil einerseits das mit der Probensubstanz gefüllte Probengläschen durch seine relativ große Masse entsprechend große Wärmemengen benötigt, um seine Temperatur zu ändern, und andererseits diese relativ große Wärmemenge sehr schlecht radial übertragen werden kann, weil dazwischen sowohl die Wandstärke des Glasröhrchens wie auch der Fluidstrom zwischen Probengläschen und Glasröhrchen als thermische Hindernisse wirken. Außerdem hat das Gegenstromprinzip den weiteren Nachteil, daß der Fluidstrom mehrere Male umgelenkt wird, was zu einem höheren Strömungswiderstand und damit zu höheren Drücken bei einer gegebenen Gesamtflußmenge Φ des Fluids führt.

Aufgabe der Erfindung ist es demgegenüber, eine Probentemperiervorrichtung der eingangs genannten Art anzugeben, mit der ein homogenerer Temperaturverlauf innerhalb der Meßprobe erzielt wird und der thermische Gleichgewichtszustand in der Meßprobe in möglichst kurzer Zeit erreicht werden kann.

Diese Aufgabe wird erfindungsgemäß dadurch gelöst, daß mindestens ein By-pass-Kanal vorgesehen ist, der so gestaltet ist, daß ein zweiter Teilstrom des Fluids als By-pass-Fluidstrom direkt und ohne thermisches Hindernis nur am oberen Bereich der Meßprobe vorbeigeführt wird.

Mit Hilfe des By-pass-Fluidstromes kann insbesondere der obere Teil der Meßprobe wirkungsvoll erwärmt oder gekühlt werden, so daß der Temperaturgradient innerhalb der Meßprobe verringert wird. Da der By-pass-Fluidstrom direkt und ohne thermisches Hindernis am oberen Bereich der Meßprobe vorbeigeführt wird, ist eine schnelle Einstellung des gewünschten stabilen Temperaturverlaufes innerhalb der Meßprobe möglich, wobei die Zeit bis zum Erreichen des thermischen Gleichgewichtszustandes lediglich von den thermischen Eigenschaften der Meßprobe abhängt.

Bei einer Ausführungsform der Erfindung ist ein Temperatursensor im unteren Bereich der Meßprobe im direkten Fluidstrom vorgesehen. Mit diesem Temperatursensor kann der Ist-Wert der Probentemperatur bzw. die Temperatur des an der Probe an dieser Stelle vorbeiströmenden Fluids aufgenommen werden. Ein weiterer Temperatursensor kann im oberen Bereich der Meßprobe im By-pass-Fluidstrom vorgesehen sein, um auch die Temperatur an dieser Stelle messen zu können.

Bei einer anderen Ausführungsform ist eine Einrichtung vorgesehen, die die Linienform eines NMR-Signals von der Meßprobe aufnehmen und aufgrund der Linienbreite des NMR-Signals die Temperatur der Meßprobe an einer axialen Position anzeigen kann. Durch diese indirekte Temperaturmessung können einerseits die Temperatursensoren eingespart werden, andererseits kommt die eigentlich relevante Temperatur, nämlich die der Meßprobe selbst und nicht nur deren Umgebungstemperatur zur Auswertung.

Bei einer bevorzugten Ausführungsform sind getrennte Zuführungen für den direkten Fluidstrom bzw. den By-pass-Fluidstrom zum Behälter vorgesehen. So wird erreicht, daß die Vereinigung der beiden Teilströme erst im oberen Bereich der Meßprobe erfolgt. Bei einer Weiterbildung dieser Ausführungsform sind außerdem getrennte Heiz- und/oder Kühlvorrichtungen zur Temperierung des direkten Fluidstromes bzw. des By-pass-Fluidstromes vorgesehen. Damit ist es möglich, die beiden Teilströme auf unterschiedlichen Temperaturniveaus dem Behälter zuzuführen, wodurch der erhöhte Wärmeaustausch des By-pass-Fluidstromes mit den Wänden des By-pass-Kanals gegenüber dem äußerst geringen Wärmeaustausch des direkten Fluidstromes mit seiner Umgebung von der Stelle seines Eintritts in den Behälter bis zu seinem Auftreffen auf die Meßprobe ausgeglichen werden kann.

Bei einer bevorzugten Ausführungsform ist mindestens ein Ventil vorgesehen, mit dem der Fluß des direkten Fluidstromes durch den Strömungskanal und/oder der Fluß des By-pass-Fluidstromes durch den By-pass-Kanal gesteuert werden kann. Ein solches Ventil ermöglicht eine Einstellung der Teilflüsse des Fluids, so daß auf unterschiedliche Anforderungen bei verschiedenen Messungen reagiert werden kann. Beispielsweise lassen sich durch die Wahl der Ventilöffnung bei einem gegebenen Gesamtfluß Φ die beiden Teilströme des Fluids so einstellen, daß ein möglichst kleiner Temperaturgradient über der axialen Länge der Meßprobe entsteht, ohne daß dabei die maximal erreichbare Temperatur an der Meßprobe wesentlich verringert wird.

Bei einer besonders bevorzugten Ausführungsform der erfindungsgemäßen Probentemperiervorrichtung ist eine Regeleinrichtung vorgesehen, die die Teilströme durch den Strömungskanal und den By-pass-Kanal so regelt, daß eine vorgebbare Regelgröße konstant gehalten wird. Mit dieser Regeleinrichtung ist eine automatische Regelung verschiedener einstellbarer Betriebsparameter der Messung möglich.

Die vorgebbare Regelgröße kann die Temperatur im unteren oder oberen Bereich der Meßprobe, die Temperaturdifferenz zwischen dem oberen und dem unteren Bereich der Meßprobe, der Gesamtfluß Φ des Fluids, die Teilflußmenge des direkten Fluidstromes, der Teilfluß des By-pass-Fluidstromes oder ein Produkt aus mehreren dieser Parameter sein. Damit kann beispielsweise durch Regelung der absoluten Temperatur der Meßprobe ein zeitlich stabiler Temperaturverlauf innerhalb der Meßprobe erreicht werden. Besonders vorteilhaft ist auch eine Regelung der Temperaturdifferenz zwischen dem oberen und dem unteren Bereich der Meßprobe auf ein Minimum. Auch können die Fluidströme so geregelt werden, daß der thermische Gleichgewichtszustand in der Meßprobe in möglichst kurzer Zeit und mit konstanter Flußmenge des strömenden Fluids erreicht wird.

Bei einer besonders bevorzugten Ausführungsform der erfindungsgemäßen Probentemperiervorrichtung ist im oberen Bereich der Meßprobe eine Wärmeaustauschvorrichtung vorgesehen, die den mit dem By-pass-Fluidstrom vereinigten direkten Fluidstrom um die Meßprobe konzentriert. Damit wird eine effektive Temperierung des oberen Meßprobenabschnittes durch den vereinigten Fluidstrom ohne störende thermische Hindernisse erreicht. Die Wärmeaustauschvorrichtung kann die Form eines Leitrohres haben, welches die Meßprobe in seinem oberen Bereich auf einer axialen Austauschlänge mit geringerem radialen Abstand als in seinem unteren Bereich umschließt und in seinem unteren Bereich eine oder mehrere Umlenkflächen aufweist, die den By-pass-Fluidstrom auf die Meßprobe lenken. Dadurch wird ein inniger Kontakt des Fluidstroms mit dem oberen Bereich der Meßprobe und somit eine wirkungsvolle direkte Abkühlung bzw. Erwärmung der Probe längs der axialen Austauschlänge sichergestellt.

Bei einer vorteilhaften Weiterbildung weist die Wärmeaustauschvorrichtung eine im Verhältnis zur Masse, Wärmekapazität und thermischen Leitfähigkeit der Meßprobe geringere Masse, Wärmekapazität und thermische Leitfähigkeit auf. Dadurch bleiben die thermischen Verluste des Fluidstromes durch Wärmeabgabe an die Wärmeaustauschvorrichtung gering und der thermische Gleichgewichtszustand der Meßprobe bei der gewünschten Temperatur wird in besonders kurzer Zeit und mit einem minimalen Fluidfluß erreicht.

Bei einer besonders bevorzugten Weiterbildung der erfindungsgemäßen Probentemperiervorrichtung weist die Wärmeaustauschvorrichtung eine spiralförmige Rille auf ihrer der Meßprobe zugewandten Fläche auf, die sich in axialer Richtung über die axiale Austauschlänge erstreckt. Damit wird das in den Raum zwischen der Wärmeaustauschvorrichtung und der Meßprobe strömende Fluid gezwungen, das Probengläschen spiralförmig zu umströmen, was zu einer bedeutend vergrößerten effektiven axialen Austauschlänge bzw. zu einer bedeutend verlängerten Zeit für den Wärmeaustausch zwischen Fluid und Meßprobe führt. Besonders bei nichtrotierenden Meßproben wirkt sich dieser Effekt äußerst vorteilhaft aus.

Die Erfindung wird im folgenden anhand des in der Zeichnung dargestellten Ausführungsbeispiels näher beschrieben und erläutert. Die der Beschreibung und der Zeichnung zu entnehmenden Merkmale können bei anderen Ausführungsformen der Erfindung einzeln und für sich oder zu mehreren in beliebiger Kombination Anwendung finden. Es zeigen:
- Fig. 1: einen Axialschnitt durch eine herkömmliche Probentemperiervorrichtung;
- Fig. 2: einen Axialschnitt durch eine herkömmliche Probentemperiervorrichtung nach dem Gegenstromprinzip;
- Fig. 3: einen Axialschnitt durch eine erfindungsgemäße Probentemperiervorrichtung;
- Fig. 4a: den gemessenen Zeitverlauf der Erwärmung einer Meßprobe bei direkter Temperierung, Temperierung mit der erfindungsgemäßen Probentemperiervorrichtung und mit einer herkömmlichen Probentemperiervorrichtung nach dem Gegenstromprinzip und
- Fig. 4b: die axiale Temperaturdifferenz in der Meßprobe als Funktion des Gesamtflusses des Fluids bei rotierender und nicht rotierender Meßprobe und bei erfindungsgemäßer bzw. herkömmlicher Temperierung nach dem Gegenstromprinzip.

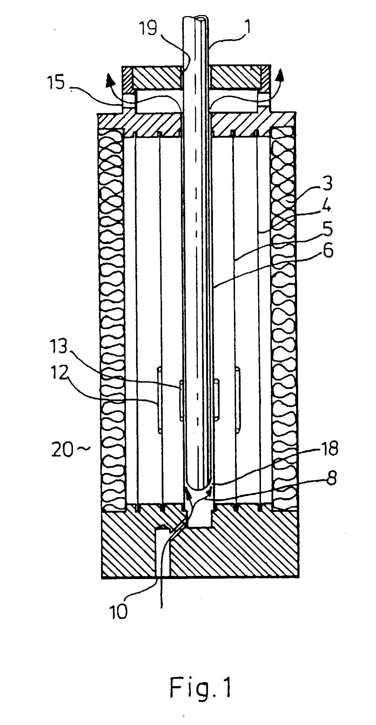

Die in Fig. 1 dargestellte herkömmliche Probentemperiervorrichtung zeigt eine Standardanordnung, wie sie vor allem in der NMR-Spektroskopie verwendet wird. Eine Meßprobe 1 ist durch eine Öffnung 19 in einen Behälter 20 mit thermischer Außenisolation 3 (z. B. Glaswolle, Schaumstoff, Vakuum etc.) eingeführt. An einem zylindrischen Trägergläschen 6, das die Meßprobe 1 umschließt, ist eine erste Hochfrequenzspule 13, in der Regel eine NMR-Empfangsspule, um die Probe herum angeordnet. In radialem Abstand umgibt ein zweites zylindrisches Trägergläschen 5 mit einer zweiten Hochfrequenzspule 12, z. B. einer NMR-Entkopplungsspule, das erste Trägergläschen 6. Eine dritte Wandung 4, z. B. ein zylindrisches Glasröhrchen, umgibt in radialem Abstand das zweite Trägergläschen 5 und dient als zusätzliche thermische Isolation der Anordnung.

Durch eine Eintrittsöffnung 10 wird ein direkter Fluidstrom 8, in der Regel ein Gasstrom, von unten an die Meßprobe 1 herangeführt und tritt in den Strömungskanal 18 zwischen Meßprobe 1 und erstem Trägergläschen 6 ein, den es am oberen Ende der Meßprobe 1 durch Austrittöffnungen 15 wieder verläßt.

Durch die direkte Zuführung des temperierenden Fluids an das Probengläschen kann die gewünschte Probentemperatur sehr schnell und mit relativ geringem Fluidfluß erreicht werden. Ein großer Nachteil dieser Anordnung ist allerdings die schlechte axiale Temperaturhomogenität innerhalb der Meßprobe, da das Probengläschen im Falle der Erwärmung unten viel wärmer wird als oben bzw. im Falle einer Abkühlung der Probe unten viel mehr gekühlt wird als oben. Durch einen höheren Fluidfluß könnte man diese Situation zwar etwas verbessern. Da jedoch der Abstand zwischen Meßprobe 1 und erstem Trägergläschen 6 aus meßtechnischen Gründen möglichst klein gehalten werden muß, um das Signal-zu-Rausch-Verhältnis nicht unnötig zuverschlechtern, würde ein Erhöhung des Fluidflusses zu einer Druckerhöhung im unteren Bereich der Meßprobe 1 führen, was eine unerlaubte axiale Verschiebung des Probengläschens nach oben zur Folge hätte.

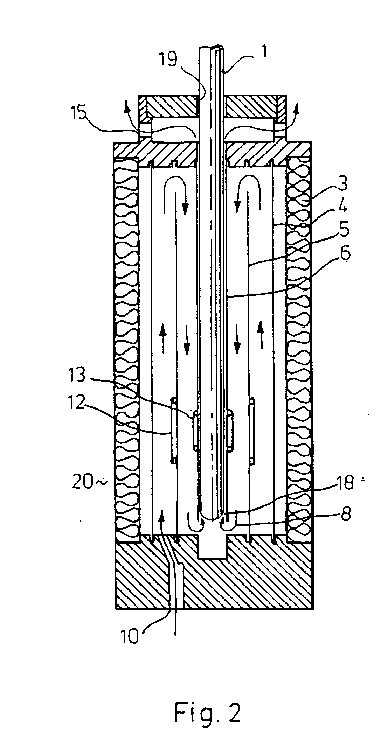

Eine verbesserte Temperaturhomogenität innerhalb der Meßprobe 1 wird in der bekannten Anordnung nach Fig. 2 erreicht, die nach dem Gegenstromprinzip funktioniert. Das temperierende Fluid tritt hier durch die Eintrittsöffnung 10 in den Behälter 20 ein und durchströmt den Raum zwischen der Wandung 4 und dem zweiten Trägergläschen 5 von unten nach oben, wird am oberen Deckel des Behälters 20 nach unten in den Raum zwischen dem ersten Trägergläschen 6 und dem zweiten Trägergläschen 5 abgelenkt, durchströmt diesen Raum von oben nach unten und wird am unteren Deckel des Behälters 20 wiederum nach oben in den Strömungskanal 18 zwischen der Meßprobe 1 und dem ersten Trägergläschen 6 umgelenkt. Den Strömungskanal 18 durchfließt der direkte Fluidstrom 8 von unten nach oben, um bei der Austrittsöffnung 15 aus dem Behälter 20 auszutreten.

Da bei dieser Anordnung im Falle der Erwärmung der Meßprobe 1 das dem Probengläschen unmittelbar benachbarte Trägergläschen 6 in seinem oberen Bereich durch den direkten Fluidstrom 8, der an diese Stelle noch kaum Wärme an die Umgebung abgegeben hat, stärker erwärmt wird als in seinem unteren Bereich, kann durch radiale Wäremübertragung vom ersten Trägergläschen 6 auf den oberen Bereich der Meßprobe 1 der bei der Anordnung nach Fig. 1 zwangsläufig entstehende axiale Temperaturabfall im Probengläschen etwas verringert werden. Da jedoch die Meßprobe 1 eine sehr viel größere Wärmekapazität und Wärmeleitfähigkeit als die übrigen vom direkten Fluidstrom 8 durchströmten Teile der Anordnung aufweist und dementsprechend eine relativ große Wärmemenge benötigt wird, um den Temperaturgradienten innerhalb der Meßprobe 1 merkbar zu beeinflussen, reicht die radiale Wärmeübertragung vom oberen Bereich des ersten Trägergläschens 6 zum oberen Bereich der Meßprobe 1 bei weitem nicht aus, um auch nur annähernd eine axiale Homogenität der Temperatur innerhalb der Meßprobe zu erzielen. Insbesondere verhindert die Wandstärke des ersten Trägergläschens 6 und der zwischen dem ersten Trägergläschen 6 und der Oberfläche des Probengläschens strömende direkte Fluidstrom 8 eine nennenswerte radiale Wärmeübertragung. Außerdem wird bei der Anordnung nach Fig. 2 der direkte Fluidstrom 8 mehrmals umgelenkt, wodurch sich ein höherer strömungswiderstand ergibt, der zu höheren Drücken bei einer gegebenen Gesamtflußmenge Φ des Fluids führt, was ebenfalls unerwünscht ist.

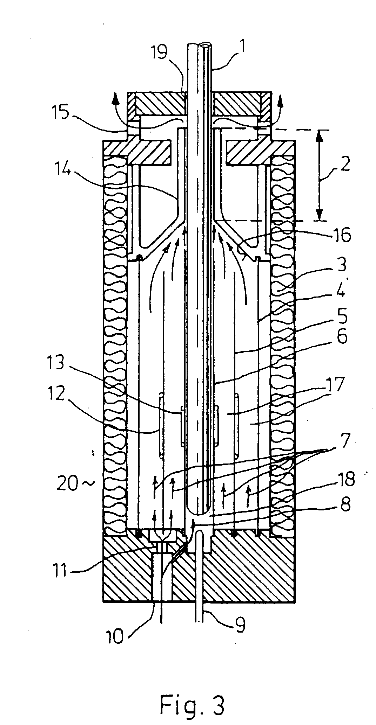

Eine Ausführungsform der erfindungsgemäßen Probentemperiervorrichtung, die sich insbesondere für den Einsatz in der NMR-Spektroskopie, aber z.B. auch in der optischen oder der Infrarotspektroskopie eignet, ist in Fig. 3 dargestellt. Das temperierende Fluid tritt durch eine Eintrittsöffnung 10 in den Behälter 20 ein, wo es in zwei Teilströme, nämlich den direkten Fluidstrom 8 und den By-pass-Fluidstrom 7 aufgeteilt wird. Der direkte Fluidstrom 8 durchströmt wie bei den herkömmlichen Vorrichtungen den Strömungskanal 18 zwischen dem ersten Trägergläschen 6 und der Meßprobe 1 von unten nach oben und kühlt oder erwärmt dabei die Meßprobe 1, wobei wie bei den bekannten Vorrichtungen ein axialer Temperaturgradient innerhalb der Meßprobe auftritt.

Um diesem Temperaturgradienten entgegenzuwirken, wird der By-pass-Fluidstrom 7, der durch einen oder mehrere By-pass-Kanäle 17 parallel zum direkten Fluidstrom 8 strömt, im oberen Bereich der Anordnung durch eine Umlenkfläche 16, die Teil einer Wärmeaustauschvorrichtung 14 sein kann, auf den oberen Bereich der Meßprobe gelenkt. Da sich an den Begrenzungsflächen der By-pass-Kanäle 17 keine Massen mit großer Wärmekapazität befinden, hat der By-pass-Fluidstrom 7 an der Stelle seines Auftreffens auf die Meßprobe 1 noch im wesentlichen dieselbe Temperatur wie bei seinem Abtrennen vom Gesamtfluidstrom. Im Falle einer Erwärmung der Meßprobe 1 ergibt sich also an der Stelle der Vereinigung der beiden Teilfluidströme im oberen Bereich der Meßprobe 1 eine wesentlich höhere Mischtemperatur des vereinigten Fluidstromes als die Temperatur des direkten Fluidstromes 8 an dieser Stelle, der auf seinem Weg durch den Strömungskanal 18 bereits eine erhebliche Wärmemenge an die Meßprobe 1 abgegeben hat. Mit Hilfe eines Ventiles 11, das im dargestellten Ausführungsbeispiel kurz nach der Eintrittsöffnung 10 angeordnet ist, kann das Flußverhältnis von direktem Fluidstrom 8 und By-pass-Fluidstrom 7 und auch der Gesamtfluß Φ des Fluids beeinflußt werden. Um im Bereich der Vereinigung der beiden Teilströme im oberen Bereich der Meßprobe eine Mischtemperatur zu erzielen, die möglichst nahe an der Temperatur des in den Behälter 20 eintretenden Fluids liegt, ist es vorteilhaft, die Flußmenge des By-pass-Fluidstromes 7 entsprechend größer zu wählen als die Flußmenge des direkten Fluidstromes 8.

Falls die Meßprobe 1 gekühlt werden soll, wird in der Regel als Fluidstrom ein Gasstrom durch Verdampfen eines verflüssigten kryogenen Gases, z. B. Flüssig-Stickstoff oder -Helium, erzeugt, wobei zugleich der erforderliche Druck zur Erzeugung eines Gasstromes aufgebaut wird. Zur Erwärmung der Probe kann der Gasstrom direkt aus einem Druckbehälter (z. B. Gasflasche) entnommen werden und muß nicht erst durch Verdampfen des verflüssigten Gases erzeugt werden. Der Gasstrom wird in Kontakt mit einer elektrisch heizbaren Heizwendel gebracht, welche den Gasstrom durch eine elektrische Regeleinrichtung auf die gewünschte Temperatur erhitzt. Über eine thermisch isolierte Zuleitung gelangt der Gasstrom dann zum Behälter 20 und an die Meßprobe 1.

Im dargestellten Ausführungsbeispiel ist im unteren Bereich der Meßprobe 1 ein Temperatursensor 9 angebracht, der mit dem direkten Fluidstrom 8 in Berührung kommt und den Ist-Wert der Temperatur des direkten Fluidstromes 8, die an dieser Stelle im wesentlichen der Temperatur des in die Eintrittsöffnung 10 eintretenden Gesamtfluidstromes entspricht, an die elektrische Temperaturregeleinrichtung weiter gibt. Die Regeleinrichtung vergleicht den Ist-Wert mit einem eingegebenen Soll-Wert und leitet daraus den erforderlichen Strom für die Heizwendel ab.

Außer dem in Fig. 3 dargestellten Temperatursensor 9 kann auch ein weiterer, nicht dargestellter, Temperatursensor im oberen Bereich der Meßprobe 1 im By-pass-Fluidstrom 7 vorgesehen sein, um auch die Temperatur an dieser Stelle messen zu können. Insbesondere wird damit die Messung der Temperaturdifferenz zwischen dem oberen und dem unteren Bereich der Meßprobe 1 ermöglicht, die ein Maß für den innerhalb der Meßprobe 1 herrschenden Temperaturgradienten darstellt.

Anstelle der direkten Temperaturmessung durch Temperatursensoren kann die Probentemperatur an einer axialen Position auch durch indirekten Rückschluß aufgrund der Linienform eines NMR-Signals der Probe ermittelt werden. Bei einem erhöhten Temperaturgradienten ergibt sich nämlich eine entsprechende Linienverbreiterung, die als Maß für die Temperatur genommen werden kann. Dadurch kann die relevante Temperatur vom Meßsignal selbst abgenommen und an die Regeleinrichtungen weitergegeben werden.

Statt der oben beschriebenen Zuführung eines Gesamtfluidstromes zur Eintrittsöffnung 10 können bei einer nicht-dargestellten Ausführungsform die Teilfluidströme, also der direkte Fluidstrom 8 und der By-pass-Fluidstrom 7 dem Behälter 20 auch getrennt zugeführt werden und sich erst im oberen Bereich der Meßprobe 1 vereinigen. Dies hat insbesondere den Vorteil, daß die Teilfluidströme auf unterschiedlichem Temperaturniveau in den Behälter 20 eintreten können. Wenn beispielsweise die Meßprobe 1 gegenüber der Umgebung aufgeheizt werden soll, so wird, wenn ein Gesamtfluidstrom wie in Fig. 3 gezeigt in die Eintrittsöffnung 10 geführt wird, die Temperatur des By-pass-Fluidstromes 7 an der Stelle seiner Vereinigung mit dem direkten Fluidstrom 8 im oberen Bereich der Meßprobe 1 geringer sein, als die Temperatur des direkten Fluidstromes 8 an der Stelle seines Auftreffens auf den unteren Bereich der Probe, weil der By-pass-Fluidstrom 7 auf seinem langen Weg durch den By-pass-Fluid-Kanal 17 wesentlich mehr Wärme an die umgebenden Wände abgegeben hat, als der direkte Fluidstrom 8 auf seinem kurzen Weg von der Eintrittsöffnung 10 zur Meßprobe 1. Daher würde in diesem Falle der obere Bereich der Meßprobe 1 bei etwa gleich großen Teilflußmengen der beiden Teilströme immer eine geringere Temperatur aufweisen als der untere Bereich, was nur durch starke Drosselung des direkten Fluidstromes 8 bzw. starke Erhöhung der Teilflußmenge des By-pass-Fluidstromes 7 ausgeglichen werden könnte. Wenn aber die beiden Teilströme auf unterschiedlichen Temperaturniveaus zugeführt werden können, kann man einfach das Temperaturniveau des By-pass-Fluidstromes 7 entsprechend höher wählen als das des direkten Fluidstromes 8 und damit den Temperaturverlust des By-pass-Fluidstromes 7 auf seinem Weg durch den By-pass-Kanal 17 kompensieren. Außerdem kann die Temperaturregeleinrichtung so ausgestaltet sein, daß die Temperaturen der beiden Teilströme getrennt geregelt werden können.

Der Behälter 20 kann bei anderen Anwendungen der Erfindung auch ein Kryostat sein, wobei dann die thermische Außenisolation 3 eine Dewarwand ist, und die ihr benachbarte innere Wandung 4 als zusätzliche thermische Isolation, z. B. in Form eines Strahlungsschildes, ausgebildet sein kann. In diesem Fall kommen als temperierende Fluide kryogene Gase wie Stickstoff oder Helium in Frage, die bei Tieftemperaturanwendungen auch im flüssigen Aggregatszustand durch den Kryostaten strömen können.

Weiterhin kann eine Regeleinrichtung vorgesehen sein, die über das Ventil 11 die Teilströme durch den Strömungskanal 18 und den By-pass-Kanal 17 so regelt, daß eine vorgebbare Regelgröße, z. B. die Temperatur im unteren oder oberen Bereich der Meßprobe 1, die Temperaturdifferenz zwischen dem oberen und dem unteren Bereich, der Gesamtfluß Φ des Fluids, die Teilflußmengen des direkten Fluidstromes 8 oder des By-pass-Fluidstromes 7 oder ein Produkt aus mehreren dieser Parameter konstant gehalten wird. Insbesondere kann die Regeleinrichtung für die Fluidflußregelung mit der oben erwähnten elektrischen Regeleinrichtung für die Gasstromtemperatur verbunden sein.

Die Wärmeaustauschvorrichtung 14 im oberen Bereich der Meßprobe 1 hat die Aufgabe, den mit dem By-pass-Fluidstrom 7 vereinigten direkten Fluidstrom 8 um die Meßprobe 1 zu konzentrieren. Im dargestellten Ausführungsbeispiel hat die Wärmeaustauschvorrichtung 14 die Form eines Leitrohres, das den oberen Bereich der Meßprobe 1 auf einer axialen Austauschlänge 2 mit geringem radialen Abstand umschließt. Im unteren Bereich der Wärmeaustauschvorrichtung 14 ist eine schräge Umlenkfläche 16 vorgesehen, die den nach oben strömenden By-pass-Fluidstrom 7 in Richtung auf die Meßprobe 1 umlenkt und zusammen mit dem direkten Fluidstrom 8 in den engen Spalt zwischen der Meßprobe 1 und dem oberen Teil der Wärmeaustauschvorrichtung 14 zwingt. Um einen möglichst guten Wärmeaustausch zwischen dem vereinigten Fluidstrom und der Meßprobe 1 zu erzielen, wird die Länge des rohrförmigen oberen Abschnittes der Wärmeaustauschvorrichtung 14 und damit die axiale Austauschlänge 2 im Verhältnis zur axialen Länge der Meßprobe 1 möglichst groß gewählt. Um die thermischen Verluste des Fluidstromes durch Wärmeabgabe an die Wärmeaustauschvorrichtung 14 möglichst gering zu halten und den thermischen Gleichgewichtszustand innerhalb der Meßprobe 1 bei der gewünschten Temperatur in möglichst kurzer Zeit mit einer minimalen Flußmenge des Fluides zu erreichen, ist es günstig, Masse, Wärmekapazität und thermische Leitfähigkeit der Wärmeaustauschvorrichtung 14 im Verhältnis zur Meßprobe 1 gering zu wählen. Besonders bei nicht rotierenden Proben ist es außerdem vorteilhaft, wenn die Wärmeaustauschvorrichtung 14 eine spiralförmige Rille auf ihrer der Meßprobe 1 zugewandten, im dargestellten Ausführungsbeispiel zylinderförmigen Fläche aufweist, die sich in axialer Richtung über die axiale Austauschlänge 2 erstreckt. Damit wird die effektive axiale Austauschlänge bzw. die Zeit für den Wärmeaustausch zwischen vereinigtem Fluidstrom und Meßprobe 1 noch einmal bedeutend vergrößert.

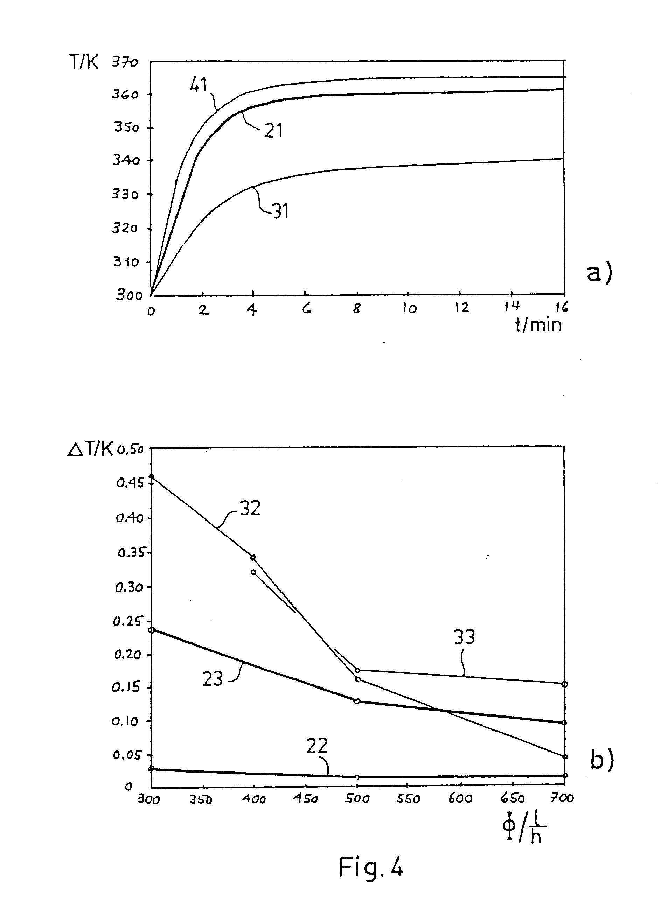

Fig. 4 zeigt die gemessenen Eigenschaften der erfindungsgemäßen Probentemperiervorrichtung im Vergleich mit einer herkömmlichen Temperiervorrichtung nach dem Gegenstromprinzip bzw. mit der direkten Temperierung der Meßprobe 1. In Fig. 4a ist der gemessene Zeitverlauf der Erwärmung der Meßprobe 1 bei direkter Temperierung (41), bei Temperierung mit der erfindungsgemäßen Probentemperiervorrichtung (21) und bei Temperierung mit einer herkömmlichen Probentemperiervorrichtung nach dem Gegenstromprinzip (31) dargestellt. Man erkennt, daß mit der erfindungs-gemäßen Probentemperiervorrichtung der thermische Gleichgewichtszustand der Meßprobe 1 nahezu gleichschnell erreicht wird wie bei der direkten Temperierung, und daß bei vorgegebener Heizleistung und vorgegebenem Fluidfluß Φ nur eine unbedeutend geringere Endtemperatur mit Hilfe der erfindungsgemäßen Probentemperiervorrichtung erreicht wird. Die Endtemperatur bei Verwendung der Probentemperiervorrichtung nach dem Gegenstromprinzip ist im Gegensatz dazu deutlich niedriger und wird auch später erreicht. Bei den Messungen von Fig. 4a wurde in einer Meßprobe 1 mit 5 mm Durchmesser der zeitliche Temperaturverlauf in der Meßprobe 1 nach dem Einschalten von 20 W Heizleistung bei einem konstanten Gasfluß Φ = 700 l/h aufgenommen. Fig. 4b zeigt die axiale Temperaturdifferenz im aktiven Bereich der 5-mm-Meßprobe, die auch für die Messungen von Fig. 4a verwendet wurde, als Funktion der gesamten Flußmenge Φ des die jeweilige Probentemperiervorrichtung durchströmenden Gases. Die mittlere Temperatur der Meßprobe 1 betrug dabei jeweils 348 K. Die Meßkurve 22 wurde an einer erfindungsgemäßen Probentemperiervorrichtung mit rotierender Meßprobe 1, die Kurve 23 an derselben Vorrichtung mit nicht-rotierender Meßprobe 1 aufgenommen, während die Meßkurve 32 an einer herkömmlichen Probentemperiervorrichtung mit Gegenstromprinzip und rotierender Probe, und die Kurve 33 an derselben herkömmlichen Vorrichtung mit nicht-rotierender Probe aufgenommen wurde. Die Temperaturhomogenität innerhalb der Meßprobe 1 übertrifft bei Temperierung mit der erfindungsgemäßen Vorrichtung die Temperaturhomogenität bei Temperierung mit der herkömmlichen Vorrichtung bei weitem. Insbesondere läßt sich mit der erfindungsgemäßen Probentemperiervorrichtung gegenüber der herkömmlichen Vorrichtung die Temperaturdifferenz zwischen dem oberen und dem unteren Bereich der Probe bei rotierender Meßprobe 1 um eine Zehnerpotenz auf Werte nahe Null herabsetzen. Gerade die Verwendung einer rotierenden Probe ist aber insbesondere in NMR-Spektroskopie Standard.

## Patentansprüche

1. Probentemperiervorrichtung, insbesondere für die NMR-Spektroskopie, mit einem Behälter (20), der eine Öffnung (19) zur Aufnahme einer Meßprobe (1), mindestens eine Eintrittsöffnung (10) zum Einlassen eines Fluids, eine Austrittsöffnung (15) für den Austritt des Fluids und einen Strömungskanal (18), durch den ein erster Teilstrom des Fluids als direkter Fluidstrom (8) von unten nach oben an der Meßprobe (1) vorbeigeführt wird, aufweist,
dadurch gekennzeichnet,
daß mindestens ein By-pass-Kanal (17) vorgesehen ist, der so gestaltet ist, daß ein zweiter Teilstrom des Fluids als By-pass-Fluidstrom (7) direkt und ohne thermisches Hindernis nur am oberen Bereich der Meßprobe (1) vorbeigeführt wird.

2. Probentemperiervorrichtung nach Anspruch 1, dadurch gekennzeichnet, daß ein Temperatursensor (9) im unteren Bereich der Meßprobe (1) im direkten Fluidstrom (8) vorgesehen ist.

3. Probentemperiervorrichtung nach Anspruch 2, dadurch gekennzeichnet, daß ein weiterer Temperatursensor im oberen Bereich der Meßprobe (1) im By-pass-Fluidstrom (7) vorgesehen ist.

4. Probentemperiervorrichtung nach Anspruch 1, dadurch gekennzeichnet, daß eine Einrichtung vorgesehen ist, die die Linienform eines NMR-Signals von der Meßprobe (1) aufnehmen und aufgrund der Linienbreite des NMR-Signals die Temperatur der Meßprobe (1) an einer axialen Position anzeigen kann.

5. Probentemperiervorrichtung nach einem der vorhergehenden Ansprüche, dadurch gekennzeichnet, daß getrennte Zuführungen für den direkten Fluidstrom (8) bzw. den By-pass-Fluidstrom (7) zum Behälter (20) vorgesehen sind.

6. Probentemperiervorrichtung nach Anspruch 5, dadurch gekennzeichnet, daß getrennte Heiz- oder Kühlvorrichtungen zur Temperierung des direkten Fluidstromes (8) bzw. des By-pass-Fluidstromes (7) vorgesehen sind.

7. Probentemperiervorrichtung nach einem der vorhergehenden Ansprüche, dadurch gekennzeichnet, daß mindestens ein Ventil (11) vorgesehen ist, mit dem der Fluß des direkten Fluidstroms (8) durch den Strömungskanal (18) und/oder der Fluß des By-pass-Fluidstromes (7) durch den By-pass-Kanal (17) gesteuert werden kann.

8. Probentemperiervorrichtung nach Anspruch 7, dadurch gekennzeichnet, daß eine Regeleinrichtung vorgesehen ist, die die Flüsse der Teilströme durch den Strömungskanal (18) und den By-pass-Kanal (17) und/oder deren Temperaturen so regelt, daß eine vorgebbare Regelgröße konstant gehalten wird.

9. Probentemperiervorrichtung nach Anspruch 8, dadurch gekennzeichnet, daß die vorgebbare Regelgröße die Temperatur im unteren oder oberen Bereich der Meßprobe (1) oder die Temperaturdifferenz zwischen dem oberen und dem unteren Bereich der Meßprobe (1) oder der Gesamtfluß Φ des Fluides oder der Teilfluß des direkten Fluidstromes (8) oder des By-pass-Fluidstromes (7) oder ein Produkt aus mehreren dieser Parameter ist.

10. Probentemperiervorrichtung nach einem der vorhergehenden Ansprüche, dadurch gekennzeichnet, daß im oberen Bereich der Meßprobe (1) eine Wärmeaustauschvorrichtung (14) vorgesehen ist, die den mit dem By-pass-Fluidstrom (7) vereinigten direkten Fluidstrom (8) um die Meßprobe (1) konzentriert.

11. Probentemperiervorrichtung nach Anspruch 10, dadurch gekennzeichnet, daß die Wärmeaustauschvorrichtung (14) die Form eines Leitrohres hat, welches die Meßprobe (1) in seinem oberen Bereich auf einer axialen Austauschlänge (2) mit geringerem radialen Abstand als in seinem unteren Bereich umschließt und in seinem unteren Bereich eine oder mehrere Umlenkflächen (16) aufweist, die den By-pass-Fluidstrom (7) auf die Meßprobe (1) lenken.

12. Probentemperiervorrichtung nach Anspruch 10 oder 11, dadurch gekennzeichnet, daß die Wärmeaustauschvorrichtung (14) eine im Verhältnis zur Masse, Wärmekapazität und thermischen Leitfähigkeit der Meßprobe (1) geringere Masse, Wärmekapazität und thermische Leitfähigkeit aufweist.

13. Probentemperiervorrichtung nach Anspruch 11 oder 12, dadurch gekennzeichnet, daß die Wärmeaustauschvorrichtung (14) eine spiralförmige Rille auf ihrer der Meßprobe (1) zugewandten Innenfläche aufweist, die sich in axialer Richtung über die axiale Austauschlänge (2) erstreckt.

## Claims

1. Temperature-control device for samples, in particular for NMR spectroscopy, comprising a vessel (20) provided with an opening (19) for receiving a measuring sample (1), at least one inlet opening (10) for introduction of the fluid, an outlet opening (15) for the outflow of the fluid and a flow channel (18) through which a first partial flow of the fluid is guided past the sample (1), as direct fluid flow, from the bottom to the top,
characterized in that
at least one by-pass channel (17) is provided which is arranged in such a way that a second partial fluid flow is guided directly and without thermal impediment past only the upper area of the sample (1) in the form of a by-pass fluid flow (7).

2. Temperature-control device for samples according to claim 1, characterized in that a temperature sensor (9) is provided in the lower area of the sample (1) in the direct fluid flow (8).

3. Temperature-control device for samples according to claim 2, characterized in that an additional temperature sensor is provided in the upper area of the sample (1) in the by-pass fluid flow (7).

4. Temperature-control device for samples according to claim 1, characterized in that a device is provided which is capable of detecting the lineshape of an NMR signal from the sample (1) and of indicating the temperature of the sample (1) at an axial position based on the line width of the NMR signal.

5. Temperature-control device for samples according to one of the preceding claims, characterized in that separate supply lines are provided for the direct fluid flow (8) or the by-pass fluid flow (7) to the vessel (20).

6. Temperature-control device for samples according to claim 5, characterized in that separate heating or cooling devices are provided for controlling the temperature of the direct flow (8) or of the by-pass fluid flow (7).

7. Temperature-control device for samples according to claim 1, characterized in that at least one valve (11) is provided for controlling the flow, i.e. the direct fluid flow (8) through the flow channel (18) and/or the by-pass fluid flow (7) through the by-pass channel (17).

8. Temperature-control device for samples according to claim 7, characterized in that a control device is provided which controls the flow rates of the partial flows through the flow channel (18) and the by-pass channel (17) and/or their temperatures in such a way that a presettable controlled variable can be kept constant.

9. Temperature-control device for samples according to claim 8, characterized in that the presettable controlled variable is the temperature in the lower or upper area of the sample (1) or the temperature difference between the upper and the lower areas of the sample (1) or the total fluid flow Φ or the partial flow rate of the direct fluid flow (8) or the by-pass fluid flow (7) or a product of a plurality of these parameters.

10. Temperature-control device for samples according to one of the preceding claims, characterized in that a heat-exchanger system (14) is provided in the upper area of the sample (1), which system concentrates the direct fluid flow (8) around the sample (1), after it has been united with the by-pass fluid flow (7).

11. Temperature-control device for samples according to claim 10, characterized in that the heat-exchanger system (14) has the form of a conduit tube which encloses the upper area of the sample (1) over an axial length of exchange (2), at a smaller radial spacing than in its lower area, and which comprises in its lower area one or more baffles (16) which act to deflect the by-pass fluid flow (7) in a direction toward the sample (1).

12. Temperature-control device for samples according to claim 10 or 11, characterized in that the heat-exchanger system (14) has a big axial length of exchange (2) relative to the axial length of the sample (1), and small mass, thermal capacity and thermal conductivity relative to the mass, thermal capacity and thermal conductivity of the sample (1).

13. Temperature-control device for samples according to claim 11 or 12, characterized in that the heat-exchanger system (14) comprises on its inner surface facing the sample (1) a spiral groove extending axially over the axial length of exchange (2).

## Revendications

1. Dispositif pour amener un échantillon à température, en particulier pour la spectroscopie par résonance magnétique nucléaire, comprenant une enceinte (20) qui présente une ouverture (19) destinée à recevoir un échantillon de mesure (1), au moins une ouverture d'entrée (10) pour faire entrer un fluide, une ouverture de sortie (15) pour la sortie du fluide et un canal d'écoulement (18) à travers lequel on fait passer de bas en haut le long de l'échantillon de mesure (1) un premier courant partiel de fluide qui sert de courant de fluide direct (8), caractérisé par le fait qu'il est prévu au moins un canal de dérivation (17) qui est conformé d'une manière telle qu'un deuxième courant partiel de fluide soit amené à passer uniquement le long de la région supérieure de l'échantillon de mesure (1), en tant que courant de fluide de dérivation (7), et ce, directement et sans obstacles thermiques.

2. Dispositif pour amener un échantillon à température selon la revendication 1, caractérisé par le fait qu'un capteur de température (9) est prévu dans la région inférieure de l'échantillon de mesure (1) dans le courant de fluide direct (8).

3. Dispositif pour amener un échantillon à température selon la revendication 2, caractérisé par le fait qu'un autre capteur de température est prévu dans la région supérieure de l'échantillon de mesure (1) dans le courant de fluide de dérivation (7).

4. Dispositif pour amener un échantillon à température selon la revendication 1, caractérisé par le fait qu'il est prévu un dispositif qui peut enregistrer la forme des raies d'un signal de résonance magnétique nucléaire de l'échantillon de mesure (1) et afficher la température de l'échantillon de mesure (1) en un endroit dans le sens axial sur la base de la largeur des raies du signal de résonance magnétique nucléaire.

5. Dispositif pour amener un échantillon à température selon l'une des revendications précédentes, caractérisé par le fait qu'il est prévu des amenées séparées à l'enceinte (20) pour le courant de fluide direct (8) et, respectivement, pour le courant de fluide de dérivation (7).

6. Dispositif pour amener un échantillon à température selon la revendication 5, caractérisé par le fait qu'il est prévu des dispositifs séparés de chauffage ou de refroidissement pour l'amenée à température du courant de fluide direct (8) et, respectivement, du courant de fluide de dérivation (7).

7. Dispositif pour amener un échantillon à, température selon l'une des revendications précédentes, caractérisé par le fait qu'il est prévu au moins un clapet (11) au moyen duquel on peut commander le débit du courant de fluide direct (8) à travers le canal d'écoulement (18) et/ou le débit du courant de fluide de dérivation (7) à travers le canal de dérivation (17).

8. Dispositif pour amener un échantillon à température selon la revendication 7, caractérisé par le fait qu'il est prévu un dispositif de régulation qui régule les débits des courants partiels à travers le canal d'écoulement (18) et le canal de dérivation (17) et/ou leurs températures de manière à maintenir constante une valeur de régulation qui peut être prédéterminée.

9. Dispositif pour amener un échantillon à température selon la revendication 8, caractérisé par le fait que la valeur de régulation qui peut être prédéterminée est constituée par la température dans la région inférieure ou supérieure de l'échantillon de mesure (1), ou par la différence de température entre les régions supérieure et inférieure de l'échantillon de mesure (1), ou par le débit d'ensemble Φ du fluide, ou par le débit partiel du courant de fluide direct (8) ou du courant de fluide de dérivation (7) ou par un produit de plusieurs de ces paramètres.

10. Dispositif pour amener un échantillon à température selon l'une des revendications précédentes, caractérisé par le fait qu'il est prévu dans la région supérieure de l'échantillon de mesure (1) un dispositif d'échange de chaleur (14) qui concentre autour de l'échantillon de mesure (1) le courant de fluide direct (8) qui est réuni au courant de fluide de dérivation (7).

11. Dispositif pour amener un échantillon à température selon la revendication 10, caractérisé par le fait que le dispositif d'échange de chaleur (14) présente la forme d'un tube de guidage, celui-ci entourant l'échantillon de mesure (1) dans sa région supérieure sur une longueur d'échange axiale (2) à une distance dans le sens radial qui est plus faible que dans sa région inférieure, et comportant dans sa région inférieure une ou plusieurs surfaces de déviation (16) qui dévient le courant de fluide de dérivation (7) pour l'amener sur l'échantillon de mesure (1).

12. Dispositif pour amener un échantillon à température selon la revendication 10 ou 11, caractérisé par le fait que le dispositif d'échange de chaleur (14) présente une masse, une capacité thermique et une conductibilité thermique qui sont faibles par rapport à la masse, à la capacité thermique et à la conductibilité thermique de l'échantillon de mesure (1).

13. Dispositif pour amener un échantillon à température selon la revendication 11 ou 12, caractérisé par le fait que le dispositif d'échange de chaleur (14) présente sur sa surface tournée vers l'échantillon de mesure (1) une rainure en forme de spirale qui s'étend dans la direction axiale sur toute la longueur d'échange axiale (2).
